# EUROPEAN PATENT SPECIFICATION

(11) **EP 2 894 775 B1**
(45) Date of publication and mention of the grant of the patent: **20.02.2019**
(21) Application number: 12884135.0
(22) Date of filing: 04.09.2012
(51) Int. Cl.: H05K 7/14, H05K 1/14

(54) **INTELLIGENT MODULE**
INTELLIGENTES MODUL
MODULE INTELLIGENT

(43) Date of publication of application: 15.07.2015
(73) Proprietor: Fuji Electric Co., Ltd., Kawasaki-shi Kanagawa 210-9530 (JP)
(72) Inventor: TOBA Akio, Kawasaki-shi Kanagawa 210-9530 (JP); HACHISU Yasuaki, Kawasaki-shi Kanagawa 210-9530 (JP)
(74) Representative: Appelt, Christian W.
(86) International application number: PCT/JP2012/072453
(87) International publication number: WO 2014/037989

(56) References cited:
- JP-A- 2000 060 140
- JP-A- 2003 332 526
- US-A1- 2006 092 611

## Description

### Technical Field

The present invention relates to an intelligent module in which are integrated a power converter circuit formed of semiconductor switching elements which control, for example, a vehicle drive motor of an electric vehicle, a hybrid vehicle, or the like, a drive circuit which drives the switching elements, a control calculation circuit which controls the drive circuit.

### Background Art

As this kind of intelligent module (an intelligent power module: also referred to as an IPM), heretofore, the ones described in, for example, PTLs 1 and 2 are known.

That is, PTL 1 describes a motor drive inverter IPM wherein an IGBT configuring a three-phase inverter, a drive circuit thereof, a shunt resistor, a protection circuit, a connector, and the like are integrally mounted on a printed substrate.

Also, PTL 2 describes a power module wherein a heatsink, on which a power converter circuit is mounted, and an electric circuit substrate, disposed above the power converter circuit, on which are mounted a drive circuit, a board power circuit (control power circuit), a communication circuit, a temperature detection circuit, a current and voltage detection circuit, an I/O (input/output) circuit, a connector, and the like, are integrally housed in an enclosure case.

Furthermore, PTL 3 describes an inverter control device wherein a power module is configured of a first substrate on which are mounted an inverter power semiconductor element, and the like, and a second substrate on which are mounted a microcomputer, a board power circuit, a communication circuit, a temperature detector, a current and voltage detector, and the like, and wherein an I/O block section including a signal connection terminal and an input/output interface section is configured separated from the power module, thus serially communicating various commands and detection values between the communication circuit and the I/O block section.

### Citation List

### Patent Literature

PTL 1: JP-A-2003-9509 (Paragraphs [0003] and [0004], Fig. 7, and the like)
PTL 2: JP-A-2009-219274 (Paragraphs [0037] to [0041], Figs. 8 to 10, and the like)
PTL 3: Japanese Patent No. 3,332,810 (Claims 1, 3, and 4, Paragraphs [0012] to [0018] and [0051] to [0058], Figs. 1 to 4, and the like)

Furthermore, document US 2006/092611 A1 discloses an electrical power converter method and a system employing multiple output converters. This document also discloses modular units which may be assembled and that may be coupled to electronic circuitry via plug-in arrangements or through an interface with a backplane or similar mounting and interconnecting structures.

### Summary of Invention

### Technical Problem

As is clear from PTLs 1 to 3, in the heretofore known intelligent module, it is common that the power converter circuit, the drive circuit, the board power circuit, the control calculation circuit, the protection circuit, the communication circuit, the temperature detection circuit, the I/O circuit, the connector, and the like are mounted on a singularity or plurality of the printed substrates to integrate all of them.

However, depending on a customer, there is a case in which the board power circuit is mounted on a substrate different from that of the module, or a case in which the method of cooling the board power circuit is different and the power circuit is shared as a power source for another power converter circuit, and furthermore, I/O circuits connected to the intelligent module are not uniform in kind and number either, meaning that it is difficult to mount the board power circuit, the I/O circuit, the connector, and the like in the module in a typical mann
er.

Consequently, there is the problem that the configuration of the intelligent module cannot help but vary in compliance with specifications required by every customer, and as a result, lacks in the mass productivity of the intelligent module, thus leading to an increase in cost.

According to the heretofore known technology of PTL 3, there are the advantages that it is possible to configure a power module capable of responding to a plurality of kinds of I/O block sections, that it is possible to simplify wiring by carrying out serial communication between the power module and the I/O block section, and the like. In the heretofore known technology, however, as the board power circuit, the connector, and the like are mounted on the power module, when the specifications of the board power circuit, connector, and the like vary depending on a customer, the configuration of the power module also varies, and the problems of mass productivity and cost still remain unsolved.

Therefore, a problem to be solved by the invention is in that an intelligent module is configured separated into a common section formed of basic components common to a large number of customers and a customized section complying with customer specifications, thereby enhancing versatility and mass productivity, enabling a reduction in cost.

### Solution to Problem

In order to solve the heretofore described problem, the invention according to claim 1 is such that an intelligent module, which has at least a switching element module formed of semiconductor switching elements configuring a power converter circuit, a drive circuit for driving the switching elements, a control calculation circuit for controlling the drive circuit, a communication circuit, and a board power circuit, includes
a common section in which a singularity or plurality of printed substrates, on which circuit components including the drive circuit, the control calculation circuit, and the communication circuit are mounted, and the switching element module are integrally formed; and
a customized section, separated from the common section, wherein circuit components including the board power circuit are mounted on a printed substrate in compliance with customer specifications,
wherein that the components include the board power circuit for supplying control power to individual portions of the intelligent module, an input/output circuit for operating various input/output devices including a speed detector of a load driven by the power converter circuit, and a connector for connecting the load and the input/output devices.

The invention according to claim 2 is such that in the intelligent module according to claim 1, the common section is integrally molded by an insulating resin.

The invention according to claim 3 is such that in the intelligent module according to claim 1 or 2, an exchange of signals between the common section and the customized section is carried out by serial communication.

The invention according to claim 4 is such that in the intelligent module according to claim 3, the customized section includes an input/output circuit having a plurality of input/output terminals, and an exchange of signals between a CPU included in the common section and the plurality of input/output terminals included in the customized section is carried out by serial communication between the CPU and the input/output circuit.

### Advantageous Effects of Invention

According to the invention of claim 1, a common section is configured by integrating a printed substrate on which are mounted circuit components including a drive circuit, control calculation circuit, and communication circuit which can be commonly used for a large number of customers and a switching element module acting as a power converter circuit, while circuit components including a board power circuit and the like whose circuit configuration and layout can vary according to customer specifications, forming a customized section, are separated from the common section, thereby enabling a reduction in cost owing to the mass production of the common section.

According to the invention of claim 2, it is possible to dispose the switching element module and printed substrate, which are large in potential difference therebetween, closely to each other, thus enabling a reduction in the size and thickness of the common section.

According to the invention of claim 3 or 4, as it is possible to reduce the number of input/output pin terminals of an CPU or the like configuring the control calculation circuit in the common section, it is possible to use an inexpensive and small circuit component.

### Brief Description of Drawings

Fig. 1 is an outline configuration diagram showing a first embodiment of the invention.
Fig. 2 is an outline configuration diagram showing a second embodiment of the invention.
Fig. 3 is a diagram showing a condition in which a common section and a customized section are connected in each embodiment.

### Description of Embodiments

Hereafter, a description will be given, along the drawings, of embodiments of the invention.

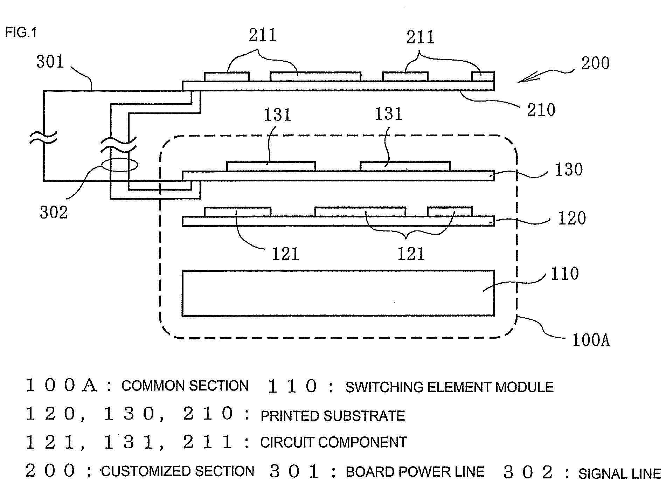

Fig. 1 is an outline configuration diagram of an intelligent module according to a first embodiment of the invention. In Fig. 1, the intelligent module according to the first embodiment is configured of a common section 100A, a customized section 200, and a board power line 301 and signal lines 302 which connect the two.

The common section 100A includes a switching element module 110 formed of semiconductor switching elements such as an IGBT configuring a power converter circuit such as an inverter, a first printed substrate 120 on which circuit components 121, 121, and so on are mounted, and a second printed substrate 130 on which circuit components 131, 131, and so on are equally mounted, and the switching element module 110, the first printed substrate 120 and circuit components 121, and the second printed substrate 130 and circuit components 131 are integrally molded by an insulating resin (not shown).

A fluid pipe or the like for water cooling or air cooling the switching elements may be attached to the switching element module 110.

The circuit components 121 mounted on the first printed substrate 120 are components configuring, for example, a drive circuit (gate drive unit) for turning on and off the switching elements in the switching element module 110, a protection circuit for protecting the switching elements and the like against overheat, overcurrent, and overvoltage, temperature, current, and voltage detection circuits (various kinds of sensors), and an interface circuit thereof. Also, the circuit components 131 mounted on the second printed substrate 130 are components configuring, for example, the previously described drive circuit and protection circuit, a control calculation circuit such as a CPU which executes a control operation of a communication circuit to be described hereafter, the communication circuit for transmitting and receiving various control commands and the detection values of temperature, current, voltage, and the like with the external, and an interface circuit thereof.

Meanwhile, the customized section 200 includes a printed substrate 210 on which circuit components 211, 211, and so on are mounted. Herein, the circuit components 211 are components configuring a board power circuit (control power circuit) for supplying control power to individual portions of the intelligent module, an I/O (input/output) circuit for operating various input/output devices (such as a speed detector of a load (motor) driven by the power converter circuit, a display, and an alarm), an interface circuit, a connector for connecting the load and the input/output devices, and the like.

The board power circuit provided in the customized section 200 is a circuit which generates a predetermined size of control power voltage from a direct current power source such as a battery supplied by a customer side. Also, the circuit components 211, such as the I/O circuit, the interface circuit, and the connector, including the board power circuit are such that the kind, number, rating, circuit configuration, layout, and the like thereof can be optionally designed in compliance with customer specifications.

Main power supplied to the switching element module 110 (power converter circuit), a main circuit capacitor (smoothing capacitor) of the power converter circuit, a switch such as a relay, and the load are also supposed to be connected by the customer side.

Also, in Fig. 1, the illustration of a wire, a support member, and the like between the switching element module 110, the first printed substrate 120, and the second printed substrate 130 is omitted.

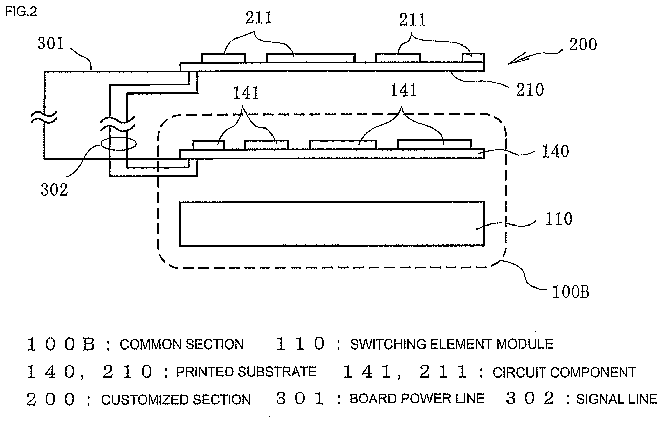

Next, Fig. 2 is an outline configuration diagram showing a second embodiment of the invention, and the second embodiment is an example wherein the first printed substrate 120 and second printed substrate 130 in the first embodiment are integrated into one printed substrate 140, and wherein circuit components equivalent to the circuit components 121 and 131 are mounted on the printed substrate 140, thus configuring a common section 100B together with a switching element module 110. The configuration of a customized section 200 is the same as in the first embodiment.

In Fig. 2 too, the illustration of a wire and support member between the switching element module 110 and the printed substrate 140 is omitted, and the switching element module 110, the printed substrate 140, and the circuit components 141 are integrally molded by an insulating resin (not shown).

According to the second embodiment, there is a possibility that the plane area of the printed substrate 140 and thus the common section 100B is larger than in the first embodiment, but as the number of printed substrates is small, it is possible to reduce the thickness of the common section 100B.

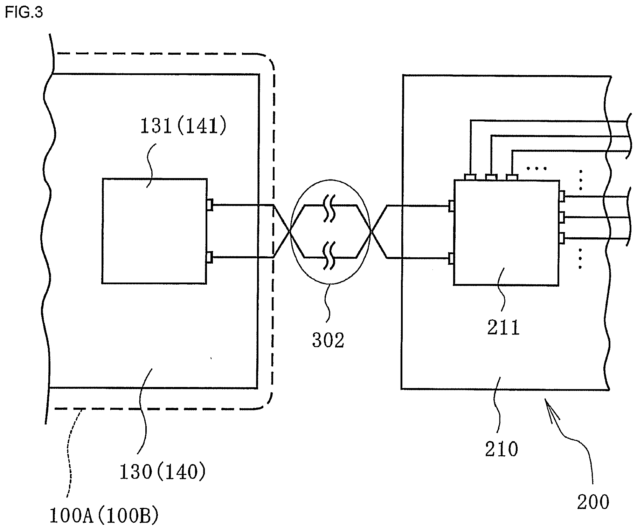

Next, Fig. 3 is a diagram showing a condition in which the common section and customized section in each embodiment are connected.

For example, for a customer who uses a large number of input/output devices, it is necessary to mount on the customized section an I/O circuit having a large number of input/output pin terminals. In this case, when a component having a number of input/output pin terminals corresponding to the number of pin terminals of the I/O circuit is used as a control calculation circuit such as a CPU to be mounted on the common section, there is the fear of causing an increase in the size of the control calculation circuit and thus the common section and an increase in cost.

Therefore, in the invention, for example, when the circuit component 131 (141) mounted on the printed substrate 130 (140) in the common section 100A (100B) is a CPU or the like configuring the control calculation circuit, and the circuit component 211 mounted on the printed substrate 210 of the customized section 200 is an IC or the like for the I/O circuit, a configuration is adopted such that the two components are connected by the pair of signal lines 302, and an exchange of signals between the two components is carried out by serial communication, as shown in Fig. 3. In Fig. 3, the illustration of the board power line 301 in Figs. 1 and 2 is omitted.

By so doing, a component having a small number of pin terminals can be used as the circuit component 131 (141) formed of a CPU or the like, thus enabling a reduction in the size of the common section 100A (100B) and a reduction in cost.

Also, as heretofore described, in each embodiment, the common section 100A, 100B is integrally molded by an insulating resin. This kind of intelligent module is such that a potential difference of several hundred volts [V] may exist between the switching element module 110 and the printed substrate 120, 130, 140, and that with so-called air insulation, a distance of 5 to 6 [m] has to be secured between the two. As opposed to this, by integrally molding the common section 100A, 100B using an insulating resin and forming a resin seal between the switching element module 110 and the printed substrate 120, 130, 140, it is possible to reduce an insulation distance and dispose individual members closely to each other, thus enabling a reduction in the size and thickness of the common sections 100A and 100B and thus the whole of the intelligent module.

### Reference Signs List

- 100A, 100B:: Common section
- 110:: Switching element module
- 120, 130, 140, 210:: Printed substrate
- 121, 131, 141, 211:: Circuit component
- 200:: Customized section
- 301:: Board power line
- 302:: Signal line

## Claims

1. An intelligent module which has at least a switching element module formed of semiconductor switching elements configuring a power converter circuit, a drive circuit for driving the switching elements, a control calculation circuit for controlling the drive circuit, a communication circuit, and a board power circuit, the intelligent module including:
a common section (100A) in which a singularity or plurality of printed substrates, on which circuit components (121, 131) including the drive circuit, the control calculation circuit, and the communication circuit are mounted, and the switching element module (110) are integrally formed; and
a customized section (200), separated from the common section, wherein circuit components including the board power circuit are mounted on a printed substrate (210) in compliance with customer specifications,
**characterized in that** the components include the board power circuit for supplying control power to individual portions of the intelligent module, an input/output circuit for operating various input/output devices including a speed detector of a load driven by the power converter circuit, and a connector for connecting the load and the input/output devices.

2. The intelligent module according to claim 1, **characterized in that** the common section is integrally molded by an insulating resin.

3. The intelligent module according to claim 1 or 2, **characterized in that** an exchange of signals between the common section and the customized section is carried out by serial communication.

4. The intelligent module according to claim 3, **characterized in that**
the customized section includes an input/output circuit having a plurality of input/output terminals, and
an exchange of signals between a CPU included in the common section and the plurality of input/output terminals included in the customized section is carried out by serial communication between the CPU and the input/output circuit.

## Patentansprüche

1. Intelligentes Modul, das mindestens ein Schaltelementmodul aufweist, das aus Halbleiterschaltelementen gebildet ist, die eine Leistungswandlerschaltung konfigurieren, eine Treiberschaltung zum Treiben der Schaltelemente, eine Steuerberechnungsschaltung zum Steuern der Treiberschaltung, eine Kommunikationsschaltung und eine Plattenleistungsschaltung, wobei das intelligente Modul Folgendes aufweist:
einen gemeinsamen Abschnitt (100A), in dem ein einziges oder eine Mehrzahl gedruckter Substrate, auf welchen Schaltungsbauteile (121, 131), einschließlich der Treiberschaltung, der Steuerberechnungsschaltung und der Kommunikationsschaltung montiert sind, und das Schaltelementmodul (110) integral gebildet sind; und
einen kundenspezifischen Abschnitt (200), der von dem gemeinsamen Abschnitt getrennt ist, wobei Schaltungsbauteile, die die Plattenleistungsschaltung aufweisen, auf einem gedruckten Substrat (210) in Übereinstimmung mit Kundenspezifikationen montiert sind,
**dadurch gekennzeichnet, dass** die Bauteile die Plattenleistungsschaltung zum Liefern von Steuerleistung zu individuellen Abschnitten des intelligenten Moduls aufweisen, eine Eingangs-/Ausgangsschaltung zum Betreiben diverser Eingangs-/Ausgangsbauelemente, einschließlich eines Geschwindigkeitsdetektors einer Last, die von der Leistungswandlerschaltung getrieben wird, und einen Stecker zum Verbinden der Last und der Eingangs-/Ausgangsbauteile.

2. Intelligentes Modul nach Anspruch 1, **dadurch gekennzeichnet, dass**
der gemeinsame Abschnitt integral durch ein isolierendes Harz überformt ist.

3. Intelligentes Modul nach Anspruch 1 oder 2, **dadurch gekennzeichnet, dass**
ein Austausch von Signalen zwischen dem gemeinsamen Abschnitt und dem kundenspezifischen Abschnitt durch serielle Kommunikation ausgeführt wird.

4. Intelligentes Modul nach Anspruch 3, **dadurch gekennzeichnet, dass**
der kundenspezifische Abschnitt eine Eingangs-/Ausgangsschaltung aufweist, die eine Mehrzahl von Eingangs-/Ausgangsklemmen aufweist, und
ein Austausch von Signalen zwischen einer CPU, die in dem gemeinsamen Abschnitt enthalten ist, und der Mehrzahl von Eingangs-/Ausgangsklemmen, die in dem kundenspezifischen Abschnitt enthalten sind, durch serielle Kommunikation zwischen der CPU und der Eingangs-/Ausgangsschaltung ausgeführt wird.

## Revendications

1. Module intelligent qui comporte au moins un module d'éléments de commutation constitué d'éléments de commutation à semi-conducteurs configurant un circuit de conversion de puissance, un circuit de commande pour commander les éléments de commutation, un circuit de calcul de commande pour commander le circuit de commande, un circuit de communication, et un circuit de puissance de carte, le module intelligent comprenant :
une section commune (100A) dans laquelle un seul substrat imprimé ou une pluralité de substrats imprimés, sur lesquels des composants de circuits (121, 131) comprenant le circuit de commande, le circuit de calcul de commande, et le circuit de communication sont montés, et le module d'éléments de commutation (110) sont formés d'un seul tenant ; et
une section personnalisée (200), séparée de la section commune, dans lequel les composants de circuits comprenant le circuit de puissance de carte sont montés sur un substrat imprimé (210) en conformité avec des spécifications de client,
**caractérisé en ce que** les composants comprennent le circuit de puissance de carte pour fournir une puissance de commande à des parties individuelles du module intelligent, un circuit d'entrée/sortie pour mettre en oeuvre divers dispositifs d'entrée/sortie comprenant un détecteur de vitesse d'une charge commandée par le circuit de conversion de puissance, et un connecteur pour connecter la charge et les dispositifs d'entrée/sortie.

2. Module intelligent selon la revendication 1, **caractérisé en ce que**
la section commune est moulée intégralement par une résine isolante.

3. Module intelligent selon la revendication 1 ou 2, **caractérisé en ce que**
un échange de signaux entre la section commune et la section personnalisée est effectué par une communication série.

4. Module intelligent selon la revendication 3, **caractérisé en ce que**
la section personnalisée comprend un circuit d'entrée/sortie comportant une pluralité de bornes d'entrée/sortie, et
un échange de signaux entre une CPU incluse dans la section commune et la pluralité de bornes d'entrée/sortie incluses dans la section personnalisée est effectué par une communication série entre la CPU et le circuit d'entrée/sortie.
